# EUROPÄISCHE PATENTSCHRIFT

(11) **EP 2 870 510 B1**
(45) Veröffentlichungstag und Bekanntmachung des Hinweises auf die Patenterteilung: **21.10.2015**
(21) Anmeldenummer: 12756711.3
(22) Anmeldetag: 06.09.2012
(51) Int. Cl.: G03F 7/00

(54) **STRUKTURSTEMPEL, VORRICHTUNG UND VERFAHREN ZUM PRÄGEN**
STRUCTURE STAMP, DEVICE AND METHOD FOR EMBOSSING
POINÇON STRUCTURÉ, DISPOSITIF ET PROCÉDÉ POUR L'ESTAMPAGE

(43) Veröffentlichungstag der Anmeldung: 13.05.2015
(60) Teilanmeldung: 15173112.2
(73) Patentinhaber: Ev Group E. Thallner GmbH, 4782 St. Florian am Inn (AT)
(72) Erfinder: FISCHER, Peter, A-4775 Taufkirchen an der Pram (AT); KREINDL, Gerald, A-4780 Schärding (AT); HARMING, Jakob, 8850 Bjerringbro (DK); THANNER, Christine, 84378 Dietersburg (DE); SCHÖN, Christian, A-4770 Andorf (AT)
(74) Vertreter: Schweiger, Johannes
(86) Internationale Anmeldenummer: PCT/EP2012/067430
(87) Internationale Veröffentlichungsnummer: WO 2014/037044

(56) Entgegenhaltungen:
- WO-A1-2006/135170
- WO-A2-03/065120
- US-A1- 2004 197 712
- US-A1- 2006 231 979
- US-A1- 2008 271 628
- US-A1- 2012 193 832

## Beschreibung

Die vorliegende Erfindung betrifft einen Strukturstempel zum Prägen gemäß Patentanspruch 1, eine Vorrichtung gemäß Patentanspruch 9 und ein Verfahren gemäß Patentanspruch 10.

Der heutige Stand der Technik für die Mikro- und/oder Nanostrukturierung von Oberflächen umfasst vor allem die Photolithographie und die unterschiedlichen Prägetechniken. Die Prägetechniken arbeiten entweder mit harten oder weichen Stempeln. In letzter Zeit setzen sich vor allem die Prägelithographietechniken durch und verdrängen die klassischen Photolithographietechniken. Unter den Prägelithographietechniken wird vor allem die Verwendung von sogenannten weichen Stempeln immer beliebter. Der Grund liegt in der leichten Herstellung der Stempel, effizienten Prägevorgängen, sehr guten Oberflächeneigenschaften der jeweiligen Stempelmaterialien, den geringen Kosten, der Reproduzierbarkeit des Prägeproduktes und vor allem in der Möglichkeit der elastischen Verformung des Stempels während der Entformung. In der Softlithographie wird ein Stempel aus einem Elastomer mit einer mikro- bzw. nanostrukturierten Oberfläche verwendet, um Strukturen im Bereich von 20 nm bis >1000 µm herzustellen.

Es gibt sechs bekannte Techniken:
- Mikro- und/oder Nanokontaktdrucken (µ/nCP)
- Replikagießen (REM)
- Microtransfer moulding (µTM) oder nanoimprint lithographie (NIL),
- Mikroformung in Kapillaren (MIMIC)
- lösungsmittelunterstützten Mikroformen(SAMIM) und
- Phaseshift Lithographie.

Elastomere Stempel werden als Negativ eines Masters hergestellt. Beim Masterstempel handelt es sich um einen Hartstempel aus Metall oder Keramik, der durch entsprechend aufwendige Prozesse einmal hergestellt wird. Aus dem Master können dann beliebig viele elastomere Stempel hergestellt werden. Die elastomeren Stempel ermöglichen einen konformen, gleichmäßigen Kontakt über große Oberflächen. Sie sind leicht von ihrem Masterstempel, sowie von den Prägeprodukten zu trennen. Weiterhin haben elastomere Stempel eine geringe Oberflächenspannung für eine leichte und einfache Trennung von Stempel und Substrat. Zur automatisierten Realisierung von soft lithographischen Prozessen ist es nötig, den elastomeren Stempel durch einen Träger zu unterstützen. Derzeit werden Glasträgersubstrate mit verschiedenen Dicken verwendet. Durch die Verwendung dicker Glassubstrate verliert der elastomere Stempel allerdings, zumindest teilweise, seine Flexibilität.

Die Verwendung von starren Trägern erschwert das automatische Trennen von Stempel und Substrat nach dem Prägeprozess wodurch eine Prozessautomatisierung und eine industrielle Verwertbarkeit der Imprintlithographie nur schwer möglich sind.

Aufgabe der vorliegenden Erfindung ist es daher, eine Vorrichtung und ein Verfahren für die Mikro- und/oder Nanostrukturierung anzugeben, mit welchen eine Automatisierung und ein schnellerer Prozessablauf gewährleistet werden können.

Diese Aufgabe wird mit den Merkmalen der Patentansprüche 1, 9 und 10 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen.

Die Erfindung beschreibt ein Verfahren und eine Vorrichtung, bei welchen ein Strukturstempel, bestehend aus einem mikro- und/oder nanostrukturierten, insbesondere zumindest teilweise, vorzugsweise überwiegend, elastomeren Stempel, insbesondere Folienstempel, und einem Rahmen, verwendet wird. Der Stempel wird auf einer Beaufschlagungsseite erfindungsgemäß entlang seiner gesamten Länge, insbesondere in einem kontinuierlichen Prozess, mit einer, insbesondere sich quer zur Länge erstreckenden, Linienkraft beaufschlagt, um die Strukturen in das Prägematerial zu drücken. Mit Vorzug erfolgt die Beaufschlagung mit Hilfe eines Prägeelements, insbesondere einer, vorzugsweise starren, Prägerolle.

Unter einem Stempel wird im weiteren Verlauf jede Art von Bauteil verstanden, welches entsprechende Strukturelemente an seiner Oberfläche besitzt und die erfindungsgemäße Flexibilität beim Prägeprozess aufweist. Es kann sich bei einem Stempel um ein einzelnes oder um ein zusammengesetztes Bauteil handeln. Ist der Stempel nur als einzelnes Bauteil ausgeführt, so besteht der Stempel aus einer Folie oder einer flexiblen Platte, in welcher die entsprechenden Strukturelemente erzeugt worden sind. Im Falle eines zusammengesetzten Stempels besteht dieser aus einem Träger und einem entsprechenden, die Strukturelemente aufweisenden, Stempelbauteil. Träger und/oder Stempelbauteil müssen in diesem Fall als Bauteilgruppe die nötige Flexibilität aufweisen, um vom Prägeelement entsprechend verformt werden zu können.

Linienkraft gemäß der vorliegenden Erfindung bedeutet, dass die Kraftbeaufschlagung zwar in einer ersten Richtung, insbesondere quer zur Bewegung eines Prägeelements entlang des Stempels, zumindest überwiegend, insbesondere vollständig, erfolgt (also beispielsweise die gesamte wirksame Breite des Stempels erfasst), während in einer zweiten Richtung (insbesondere quer zur ersten Richtung) nur ein vergleichsweise sehr kleiner Bereich (insbesondere im Verhältnis 1 zu 5, vorzugsweise 1 zu 10, noch bevorzugter 1 zu 20, noch bevorzugter 1 zu 100 zur ersten Richtung) gleichzeitig beaufschlagt wird. Somit ergibt sich eine vergleichsweise kleine Beaufschlagungsfläche im Verhältnis zur Gesamtfläche des Stempels, die gleichzeitig beaufschlagt wird. Hierdurch wird nicht nur eine sehr definierte Beaufschlagung ermöglicht, sondern auch eine sehr homogene Prägung erreicht. Die Erfindung erlaubt somit außerdem eine großflächige Anwendung des Prägeverfahrens, insbesondere mit einer Breite größer als 0,5 m, vorzugsweise größer 1 m, noch bevorzugter größer 2 m und/oder einer Länge größer als 0,5 m, vorzugsweise größer 1 m, noch bevorzugter größer 2 m.

Durch die erfindungsgemäße Anordnung des Stempels in einem modulartigen Rahmen wird eine Automatisierung des Verfahrens und somit ein schnellerer Prozessablauf ermöglicht.

Der erfindungsgemäße Strukturstempel wird weitergebildet, indem der Stempel mittels zwei an den zwei gegenüberliegenden Spannseiten angeordneten Spannleisten gespannt wird. Die Spannleisten umfassen insbesondere Fixiermittel zur Fixierung des Stempels am Strukturstempel. Jede Spannleiste kann entweder direkt oder über ein Federsystem am Rahmen fixiert sein. Mit Vorzug wird allerdings mindestens eine der Spannleisten mittels Federn am Rahmen befestigt. In speziellen Ausführungsformen können auch noch weitere Spannleisten an den Längsseiten verwendet werden, um den Stempel quer zur Längsrichtung zu fixieren und/oder zu spannen. Quer zur Längsrichtung verlaufende Spannleisten dienen insbesondere zur Reduzierung, insbesondere Vermeidung, von (unkontrollierter) Querkontraktion.

Erfindungsgemäß kann der Strukturstempel Teil einer erweiterten Baugruppe sein, welche über Führungsleisten verfügt, in welchen sich das Prägelement linear bewegen lässt. In der Baugruppe sind entweder Verstellschrauben (manuelle Ausrichtung) oder Motoren (automatische Ausrichtung) verbaut um auch eine Winkelausrichtung des Stempels zu gewährleisten. Gemäß einer vorteilhaften Ausführungsform der Erfindung ist daher vorgesehen, dass zwei gegenüberliegend, insbesondere parallel zueinander, verlaufende Führungsleisten zur Führung eines Prägeelements, insbesondere einer Prägerolle, entlang einer zur Stempelfläche abgewandten Seite des Stempels angeordneten Beaufschlagungsseite des Stempels zur Führung des Prägeelements in einem Bauteil verwendet werden, welches auch den Strukturstempel aufnehmen kann. Somit wird die Bewegung des Prägeelements unmittelbar dem den Stempel fixierenden Rahmen zugeordnet, quasi entkoppelt von der das Prägeelement antreibenden Vorrichtung zur Aufnahme des Strukturstempels und einer Steuerung des Strukturstempels mit einer Steuerungseinrichtung. In den entsprechenden Ausführungsformen, in denen auch eine Längsspannung des Stempels durch mindestens eine Spannleiste an einer der beiden Längsseiten, mit Vorzug an beiden Spannseiten, erfolgt, wären die Spannseiten der Längsseite funktional identisch mit den Führungsleisten.

Soweit der Strukturstempel derart flexibel ausgebildet ist, dass der Stempel mittels eines Prägeelements über eine von dem Rahmen, insbesondere durch die Führungsleisten, definierte Oberflächenebene hinaus dehnbar ist, wird die Ausrichtung des Strukturstempels gegenüber der zu prägenden Prägefläche erleichtert und insbesondere leichter automatisierbar.

In Weiterbildung der vorliegenden Erfindung ist es vorgesehen, dass der Stempel aus einem Träger und einem hierauf gemoldeten oder heißgeprägten, insbesondere elastomeren, Stempel gebildet ist. Hierdurch wird die Herstellung des Strukturstempels günstiger.

Indem der Strukturstempel einen den Rahmen an seiner zur Stempelfläche abgewandten Seite aufnehmenden Halterahmen umfasst, wird die Automatisierung, insbesondere das Auswechseln des Strukturstempels, weiter vereinfacht, da eine Schnittstelle zwischen der erfindungsgemäßen Vorrichtung und dem Strukturstempel beziehungsweise dem Rahmen des Strukturstempels zur Verfügung gestellt wird. Der vorgenannte Halterahmen ist, insbesondere in Verbindung mit einem entlang des Rahmens geführten Prägeelement als eigenständige Erfindung anzusehen.

Dabei ist es in Weiterbildung der Erfindung und/oder des Halterahmens denkbar, das Prägeelement zwischen dem Halterahmen und dem Rahmen, insbesondere parallel zu den gegenüberliegenden Spannseiten derart zu führen, dass das Prägeelement entlang der Stempelfolie führbar ist und diese dabei mit einer Prägekraft beaufschlagend ausgebildet ist.

Als eigenständige Erfindung wird außerdem eine Vorrichtung zum Prägen eines Prägemusters auf einer Prägefläche gemäß Anspruch 9 offenbart.

Vorrichtungsgemäß wird auch eine Steuerungseinrichtung zur Steuerung des beschriebenen, erfindungsgemäßen Verfahrens und zur Ausführung der beschriebenen Bewegungen der Bauteile der Vorrichtung und/oder des Strukturstempels, insbesondere des Halterahmens, des Rahmens oder des Prägeelements, einzeln oder gemeinsam, offenbart. Entsprechende Antriebe und Führungselemente zur Ausführung der Bewegungen werden hierdurch ebenfalls der Vorrichtung zugeordnet. Die Antriebe erlauben insbesondere die von der Steuerungseinrichtung gesteuerte translatorische Bewegung des Halterahmens in x- und/oder y- und/oder z-Richtung. Mit Vorzug ist auch eine Drehung um die x- und/oder y- und/oder z-Achse möglich. Die Antriebe erlauben mit Vorzug eine Vorpositionierung des Halterahmens und damit des Strukturstempels und des Stempels relativ zur Prägemasse.

Als eigenständige Erfindung wird außerdem ein Verfahren zum Prägen eines Prägemusters auf einer Prägefläche eines Prägematerials gemäß Anspruch 10 offenbart.

Dabei ist es erfindungsgemäß vorteilhaft, wenn der Stempel flexibel ausgebildet und beim Prägen durch das Prägeelement über eine von dem Rahmen, insbesondere durch Führungsleisten, definierte Oberflächenebene hinaus gedehnt wird. Die Flexibilität wird von möglichen Federn zwischen Rahmen und Spannleisten erhöht. Obwohl die bevorzugte Ausführungsform jene mit einem Federsystem ist, kann bei ausreichender Flexibilität des Stempels auf das Federsystem verzichtet werden.

Weiterhin ist es erfindungsgemäß von Vorteil, den Rahmen an seiner zur Stempelfläche abgewandten Seite von einem Halterahmen aufzunehmen.

Dabei ist es gemäß einer vorteilhaften Ausführungsform des Verfahrens vorgesehen, dass das Prägeelement zwischen dem Halterahmen und dem Rahmen, insbesondere parallel zu den gegenüberliegenden Spannseiten, entlang des Stempels geführt wird und diese dabei mit einer Prägekraft beaufschlagt wird.

Bei entsprechend großen Ausführungen der erfindungsgemäßen Vorrichtung muss die Prägekraft entsprechend groß sein. Es werden folgende beispielhafte Wertebereiche für eine erfindungsgemäße Ausführung der Erfindung offenbart. Die beaufschlagende Prägekraft liegt im Wertebereich zwischen 0N und 1000N, mit Vorzug zwischen 0N und 100N, mit größerem Vorzug zwischen 0N und 50N, mit allergrößtem Vorzug zwischen 0N und 10N.

Vorrichtungsgemäß offenbarte Merkmale der Vorrichtung und/oder des Strukturstempels sollen auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen jeweils in schematischer Ansicht:
- Figur 1: eine schematische Querschnittsansicht einer ersten Ausführungsform der vorliegenden Erfindung, nämlich eines erfindungsgemäßen ersten Verfahrensschrittes der Ausrichtung eines erfindungsgemäßen Strukturstempels gegenüber einem auf einem Substrat aufgebrachten Prägematerial,
- Figur 2: eine schematische Querschnittsansicht eines erfindungsgemäßen zweiten Verfahrensschrittes der Annäherung des Strukturstempels an das zu prägende Prägematerial,
- Figur 3: eine schematische Querschnittsansicht eines dritten Verfahrensschrittes der Beaufschlagung des Strukturstempels mit einem Prägeelement (Beginn des Prägens),
- Figur 4: eine schematische Ansicht des Verfahrensschritts gemäß Figur 3 beim Ende des Prägens,
- Figur 5: eine schematische Querschnittsansicht einer zweiten Ausführungsform des erfindungsgemäßen Verfahrens,
- Figur 6: eine schematische, perspektivische Ansicht des erfindungsgemäßen Strukturstempels,
- Figur 7: eine schematische, vergrößerte, perspektivische Ansicht eines Querschnittelements A-A des erfindungsgemäßen Strukturstempels
- Figur 8: eine schematische, perspektivische Ansicht des erfindungsgemäßen Strukturstempels in einem Halterahmen, mit eingebautem Prägeelement und Führungsleisten

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

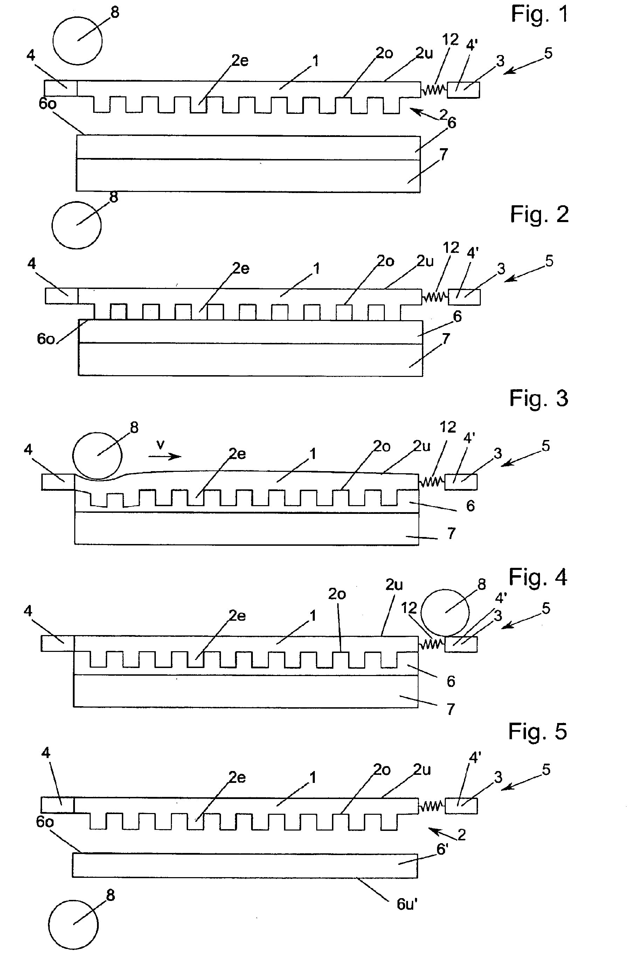

In den Figuren sind die erfindungsgemäßen Merkmale in den Figuren 1 bis 5 nicht maßstabsgetreu dargestellt, um die Funktion der einzelnen Merkmale überhaupt darstellen zu können. Auch die Verhältnisse der einzelnen Bauteile sind teilweise unverhältnismäßig, was insbesondere auf stark vergrößert dargestellte Nanostrukturen 2e zurückzuführen ist. Die Nanostrukturen 2e, die mit der vorliegenden Erfindung geprägt werden beziehungsweise zum Prägen von korrespondierenden Nanostrukturen auf Werkstücke verwendet werden, liegen im Nano- und/oder Mikrometerbereich, während die Größenordnung der Maschinenbauteile im Zentimeterbereich liegt.

Die Abmessungen der einzelnen Nanostrukturen 2e des Prägemusters 2 liegen vorzugsweise im Mikrometer- und/oder im Nanometerbereich. Die Abmessungen der einzelnen Nanostrukturen 2e sind kleiner als 1000 µm, mit Vorzug kleiner als 10 µm, mit größerem Vorzug kleiner als 100 nm, mit noch größerem Vorzug kleiner als 10 nm, mit allergrößtem Vorzug kleiner als 1 nm.

In der in Figuren 1 bis 4 und 6 gezeigten ersten Ausführungsform ist ein Strukturstempel 5 gezeigt, der aus einem Rahmen 3 und einem in den Rahmen 3 eingespannten Stempel 1 besteht.

Der Stempel 1 besitzt eine mikro- oder nanostrukturierte Stempelfläche 2 mit den Nanostrukturen 2e (Erhebungen), die von einer Trägerseite 2o des Stempels 1 hervorstehen.

Eine zur Stempelfläche 2 gegenüberliegende Beaufschlagungsseite 2u ist plan eben ausgebildet, damit eine möglichst homogene Beaufschlagung des Stempels 1 an der Beaufschlagungsseite 2u ermöglicht wird.

Zur Beaufschlagung dient ein Prägeelement 8, hier in Form einer Prägerolle, die nach Ausrichtung des Strukturstempels 5 gegenüber einem auf einem Substrat 7 aufgebrachten Prägematerial 6 (siehe Figur 1) und anschließendem Annähern des Strukturstempels 5 an eine Prägefläche 6o des Prägematerials 6 auf die Beaufschlagungsseite 2u abgesenkt wird.

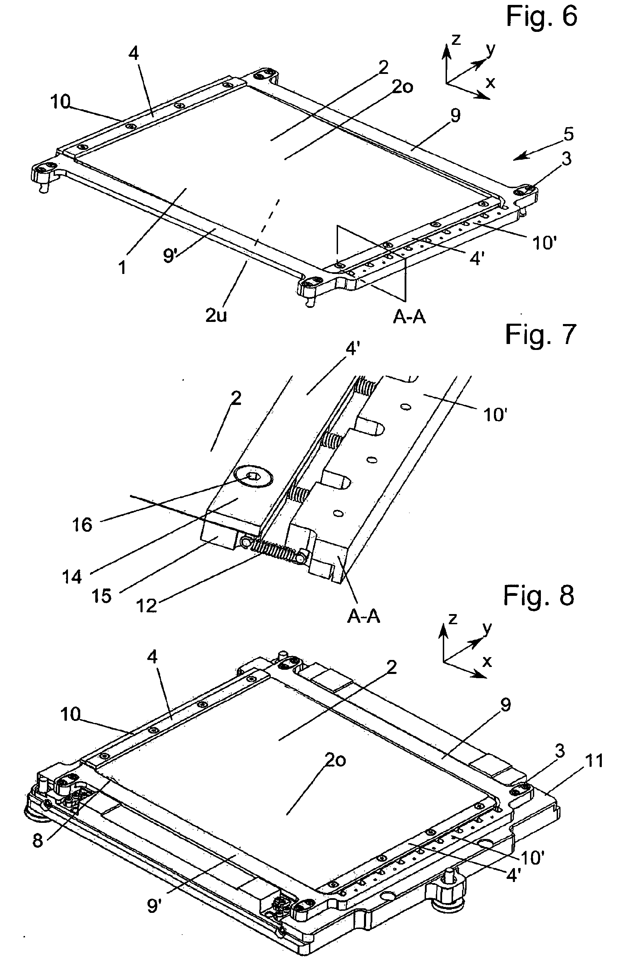

Der Rahmen 3 besitzt an zwei gegenüberliegenden Spannseiten 10, 10' mindestens ein Paar gegenüberliegende Spannleisten 4, 4', in welche der Stempel 1 eingespannt ist. Die Spannleisten 4, 4' können starr oder über ein Federsystem 13 (siehe Figuren 6 und 7) am Rahmen 3 befestigt werden. Die Verwendung eines Federsystems 13 als Kupplung zwischen mindestens einer der Spannleisten 4, 4' und dem Rahmen 3 dient der Erhöhung der Flexibilität des Stempels 1 bei Beanspruchung durch das Prägeelement 8.

Ein Federsystem 13 besteht aus mindestens zwei, mit Vorzug aus mehr als fünf, mit größerem Vorzug aus mehr als zehn, mit größtem Vorzug aus mehr als 20 Federn 12.

Die beiden Spannseiten 10, 10' werden durch zwei gegenüberliegend, parallel zueinander verlaufende Führungsleisten 9, 9' verbunden, wobei die Führungsleisten 9, 9' insbesondere nicht mit der Stempelfolie 1 in Berührung kommen. Die Stempelfolie 1 verläuft vorzugsweise innerhalb und zwischen den Führungsleisten 9, 9'.

Die Beaufschlagung der Beaufschlagungsseite 2u mit dem Prägeelement 8 erfolgt insbesondere gleichzeitig mit einer Kontaktierung beziehungsweise einem Eintauchen der Nanostrukturen 2e in das Prägematerial 6 (siehe Figur 3), wobei die Annäherung des Strukturstempels 5 an das Prägematerial 6 gemäß Figur 2 parallel (gegebenenfalls unter minimaler Anwinklung (Keilfehler) des Stempels 1 oder Strukturstempels 5) erfolgt. Die Nanostrukturen 2e tauchen in das, insbesondere aus einem Material niedriger Viskosität bestehende, Prägematerial 6 ein und während des Annäherns des Strukturstempels 5 an das Prägematerial 6 wird, insbesondere unter Parallelisierung des Stempels 1 mit dem Prägematerial 6, eine Prägekraft auf die Beaufschlagungsseite 2u durch das Prägeelement 8 übertragen. Dabei verformt sich der Stempel 1 in Richtung des Prägematerials über eine von dem Rahmen 3, insbesondere durch die Führungsleisten 9, 9', definierte Oberflächenebene E hinaus.

Denkbar ist auch eine leicht angewinkelte Annäherung des erfindungsgemäßen Strukturstempels 5 zur Oberfläche des Prägematerials 6 zunächst an einer der beiden Spannseiten 4, 4', so dass das Eintauchen der Nanostrukturen 2e nach und nach erfolgt.

Das Prägeelement 8 wird unter Annäherung des Stempels 1 (und ggf. Parallelisierung des Stempels 1) zu dem Prägematerial 6, insbesondere überwiegend durch die Prägekraft des Prägeelements 8 bewirkt, von der ersten Spannseite 4 zur gegenüberliegend angeordneten zweiten Spannseite 4' parallel zu der Oberfläche des Prägematerials 6 bewegt.

Nach Erreichen der Position gemäß Figur 4 ist die Stempelfläche 2 vollständig in dem Prägematerial 6 eingetaucht und dort entsprechend abgebildet.

Anschließend erfolgt eine Aushärtung des Prägematerials 6 und nach Aushärtung des Prägematerials 6 kann der Strukturstempel 5 abgehoben werden. Die Aushärtung kann durch alle bekannten Verfahren von der Vorder- oder Rückseite erfolgen, beispielsweise durch UV-Strahlung, durch Chemikalien oder durch Wärme, sowie durch eine Kombination der genannten Methoden.

Alternativ wie oben beschrieben, kann es beim Prägen in einem definierten Separationsabstand und Belichtung von der gegenüberliegenden Seite, mit entsprechender Prägeelementskraft (und gegebenenfalls Spannfedereinstellung) zu einer direkten Trennung nach Kontakt mit dem Prägeelement und Belichtung führen.

Der Einsatz einer Prägerolle als Prägeelement 8 bringt den Vorteil einer abrollenden Bewegung und Druckbeaufschlagung mit der Prägekraft mit sich, was zu einer Minimierung von Scherkräften auf dem Stempel 1 führt. Des Weiteren kann auf einen komplizierten Keilfehlerausgleich weitgehend verzichtet werden, der unabdingbar wäre, wenn man den Stempelprozess durch eine Normalbewegung des Stempels und des Prägematerials zueinander durchführen wollte.

Gemäß der in Figur 5 gezeigten weiteren Ausführungsform erfolgt die Druckbeaufschlagung mit dem Prägeelement 8 von der gegenüberliegenden Seite, also von der Rückseite 6u des Prägematerials 6' her, wobei eine entsprechende Gegenkraft auch hier wirkt, insbesondere durch Halterung des Rahmens 3. Das Prägematerial 6' wäre in diesem Fall zur Druckübertragung selbst geeignet oder gegebenenfalls durch ein Substrat 7 unterstützt, wie bei der Ausführungsform gemäß Figuren 1 bis 4 gezeigt. Bei dem gezeigten Prägematerial 6' kann es sich beispielsweise um eine feste aber prägbare Folie handeln.

Das Prägeelement 8 kann auch derart ausgeführt sein, dass eine kontaktlose Kraftübertragung, insbesondere durch einen Gasstrom aus einer linienförmigen Düse oder mehreren entlang einer Linie angeordneten, punktförmigen Düsen, erfolgt.

Figur 7 ist zu entnehmen, dass die Fixierung des Stempels 1 an den Spannleisten 4, 4' durch Einklemmung des Stempels 1 zwischen zwei Flachprofilen 14, 15 erfolgt. Die zur Einklemmung erforderliche Klemmkraft wird durch Fixiermittel 16 (hier: Schrauben) erzeugt.

### Bezugszeichenliste

- 1: Stempel
- 2: Stempelfläche
- 2e: Nanostrukturen
- 2o: Prägeseite
- 2u: Beaufschlagungsseite
- 3: Rahmen
- 4, 4': Spannleisten
- 5: Strukturstempel
- 6, 6': Prägematerial
- 6o: Prägefläche
- 6u: Rückseite
- 7: Substrat
- 8: Prägeelement
- 9, 9': Führungsleisten
- 10, 10': Spannseiten
- 11: Halterahmen
- 12: Feder
- 13: Federsystem
- 14: Flachprofil
- 15: Flachprofil
- 16: Fixiermittel
- E: Oberflächenebene

## Patentansprüche

1. Strukturstempel (5) mit
- einem, eine mikro- oder nanostrukturierten Stempelfläche (2) zur Prägung einer zu der Stempelfläche (2) korrespondierenden Prägestruktur auf einer Prägefläche (6o) aufweisenden, flexiblen Stempel (1),
- einem Rahmen (3) zum Einspannen des Stempels (1), **dadurch gekennzeichnet,**
**dass** der Stempel (1) derart flexibel ausgebildet ist, dass der Stempel (1) mittels eines Prägeelements (8) über eine von dem Rahmen (3) definierte Oberflächenebene E hinaus mit einer Linienkraft dehnbar ist.

2. Strukturstempel (5) nach Anspruch 1, wobei der Stempel (1) an mindestens zwei gegenüberliegenden Spannseiten (10, 10') des Rahmens (3), insbesondere mit Federn (12) federbeaufschlagt, eingespannt ist, insbesondere mittels zwei an den zwei gegenüberliegenden Seiten angeordneten Spannleisten (4, 4').

3. Strukturstempel (5) nach Anspruch 1 oder 2, bei dem der Rahmen (3) zwei gegenüberliegend, insbesondere parallel zueinander, verlaufende Führungsleisten (9, 9') zur Führung des Prägeelements (8), insbesondere einer Prägerolle, entlang einer zur Stempelfläche (2) abgewandten Seite der Stempelfolie (1) angeordneten Beaufschlagungsseite (2u) der Stempelfolie (1) aufweist.

4. Strukturstempel nach Anspruch 3, bei dem die Oberflächenebene durch die Führungsleisten (9, 9') definiert ist.

5. Strukturstempel nach einem der vorhergehenden Ansprüche, bei dem der Stempel (1) aus einem Träger und einer hierauf gemoldeten oder heißgeprägten, insbesondere nicht ausschließlich elastomeren, Stempelschicht gebildet ist.

6. Strukturstempel nach einem der vorhergehenden Ansprüche mit einem den Rahmen (3) an seiner zur Stempelfläche (2) abgewandten Seite aufnehmenden Halterahmen (11).

7. Strukturstempel nach einem der vorhergehenden Ansprüche mit einem am entlang des Rahmens (3) geführten Prägeelement (8).

8. Strukturstempel nach Anspruch 6 und 7, bei dem das Prägeelement (8) zwischen dem Halterahmen (11) und dem Rahmen (3), insbesondere parallel zu den gegenüberliegenden Spannseiten (4, 4'), derart geführt ist, dass das Prägeelement (8) entlang der Stempelfolie (1) führbar ist und diese dabei mit einer Prägekraft beaufschlagend ausgebildet ist.

9. Vorrichtung zum Prägen eines Prägemusters auf einer Prägefläche (60) mit folgenden Merkmalen:
- eine Stempelaufnahme zur Aufnahme und Bewegung eines Strukturstempels (5) nach einem der vorhergehenden Ansprüche,
- einer Prägematerialaufnahme zur Aufnahme und Anordnung eines Prägematerials (6) gegenüber dem Strukturstempel (5),
- einen Prägeelementantrieb zur Bewegung des Prägeelements (8) entlang des Strukturstempels (5).

10. Verfahren zum Prägen eines Prägemusters auf einer Prägefläche eines Prägematerials mit folgenden Schritten, insbesondere folgendem Ablauf:
- Anordnung der Stempelfläche eines Strukturstempels nach einem der Ansprüche 1 bis 8 gegenüber dem Prägematerial,
- Bewegung des Prägeelementes entlang des Strukturstempels dabei, Beaufschlagung des Strukturstempels mit der Linienkraft und dabei Prägen des Prägematerials durch Beaufschlagung des Prägematerials mit der Stempelfläche.

11. Verfahren nach Anspruch 10, bei dem der Stempel flexibel ausgebildet und beim Prägen durch das Prägeelement über eine von dem Rahmen, insbesondere durch die Führungsleisten, definierte Oberflächenebene hinaus gedehnt wird.

12. Verfahren nach Anspruch 10 oder 11, bei dem der Rahmen an seiner zur Stempelfläche abgewandten Seite von einem Halterahmen aufgenommen wird.

13. Verfahren nach Anspruch 12, bei dem das Prägeelement zwischen dem Halterahmen und dem Rahmen, insbesondere parallel zu den gegenüberliegenden Spannseiten, entlang der Stempels geführt wird und diese dabei mit einer Prägekraft beaufschlagt wird.

## Claims

1. A structure stamp (5) with
- a flexible stamp (1) which has a microstructured or nanostructured stamp surface (2) for embossing of an embossing structure which corresponds to the stamp surface (2) on an embossing surface (6o),
- a frame (3) for clamping the stamp (1), **characterized in that** the stamp (1) is made flexible
such that the stamp (1) can expand with a line force by means of an embossing element (8)beyond a surface plane E which is defined by the frame (3).

2. The structure stamp (5) as claimed in Claim 1, wherein the stamp (1) is clamped on at least two opposing clamping sides (10, 10') of the frame (3), especially spring-loaded with springs (12), especially by means of two clamping strips (4, 4') which are located on the two opposite sides.

3. The structure stamp (5) as claimed in Claim 1 or 2, wherein the frame (3) has two guide strips (9, 9') which run opposite, especially parallel to one another, for guiding the embossing element (8), especially an embossing roll, along one exposure side (2u) of the stamp film (1), which side is located along one side of the stamp film (1) facing away from the stamp surface (2).

4. The structure stamp as claimed in claim 3, wherein the surface layer is defined by the guide strips (9, 9').

5. The structure stamp as claimed in one of the preceding claims, wherein the stamp (1) is formed from a carrier and an especially not exclusively elastomer stamp layer which is hot-embossed or molded onto it.

6. The structure stamp as claimed in one of the preceding claims with a retaining frame (11) which accommodates the frame (3) on its side facing away from the stamp surface (2).

7. The structure stamp as claimed in one of the preceding claims with an embossing element (8) guided along the frame (3).

8. The structure stamp as claimed in Claim 6 and 7, wherein the embossing element (8) is guided between the retaining frame (11) and the frame (3), especially parallel to the opposite clamping sides (4, 4') such that the embossing element (8) can be guided along the stamp film (1) and the latter is made to apply an embossing force.

9. A device for embossing an embossing pattern on an embossing surface (6o) with the following features:
- a stamp receiver for accommodating and moving a structure stamp (5) according to one of the preceding claims,
- an embossing material receiver for accommodating and placing an embossing material (6) opposite the structure stamp (5),
- an embossing element drive for moving the embossing element (8) along the structure stamp (5).

10. A method for embossing an embossing pattern on an embossing surface of an embossing material with the following steps, especially the following sequence:
- placing the surface of a structure stamp as claimed in one of Claims 1 to 8 opposite the embossing material,
- moving the embossing element along the structure stamp, at the same time applying a line force to the structure stamp and at the same time embossing the embossing material by applying the stamp surface to the embossing material.

11. The method as claimed in Claim 10, wherein the stamp is made flexible and is expanded beyond the surface plane which is defined by the frame, especially by the guide strips, during embossing by the embossing element.

12. The method as claimed in Claim 10 or 11, wherein the frame on its side facing away from the stamp surface is accommodated by a retaining frame.

13. The method as claimed in Claim 12, wherein the embossing element is guided between the retaining frame and the frame, especially parallel to the opposing clamping sides, along the stamp and the latter is exposed to an embossing force.

## Revendications

1. Tampon structuré (5) comprenant
- un tampon (1) flexible présentant une surface de tampon (2) microstructurée ou nanostructurée pour marquer une structure de marquage correspondant à la surface de tampon (2) sur une surface de marquage (60),
- un cadre (3) pour tendre le tampon (1), **caractérisé en ce que**
le tampon (1) est ainsi conçu flexible que le tampon (1) peut être étiré avec une force de ligne au moyen d'un élément de marquage (8) au-delà d'un plan superficiel E défini par le cadre (3).

2. Tampon structuré (5) selon la revendication 1, dans lequel le tampon (1) est tendu sur au moins deux côtés de serrage (10, 10') opposés du cadre (3) sollicités en particulier par des ressorts (12), en particulier au moyen de deux baguettes de serrage (4, 4') disposées sur les deux côtés opposés.

3. Tampon structuré (5) selon la revendication 1 ou 2, dans lequel le cadre (3) présente deux baguettes de guidage (9, 9') opposées, en particulier parallèles entre elles, pour guider l'élément de marquage (8), en particulier un rouleau de marquage, le long d'un côté de marquage (2u) du film de tampon (1) disposé vers le côté du film de tampon (1) détourné de la surface de tampon (2).

4. Tampon structuré selon la revendication 3, dans lequel le plan superficiel est défini par les baguettes de guidage (9, 9').

5. Tampon structuré selon l'une des revendications précédentes, dans lequel le tampon (1) est formé d'un support et d'une couche de tampon meulée dessus ou marquée à chaud, en particulier non exclusivement élastomère.

6. Tampon structuré selon l'une des revendications précédentes comprenant un cadre de fixation (11) recevant le cadre (3) sur son côté détourné de la surface de tampon (2).

7. Tampon structuré selon l'une des revendications précédentes comprenant un élément de marquage (8) dirigé le long du cadre (3).

8. Tampon structuré (5) selon la revendication 6 et 7, dans lequel l'élément de marquage (8) est dirigé de telle sorte entre le cadre de fixation (11) et le cadre (3), en particulier parallèlement aux côtés de serrage (4, 4') opposés, que l'élément de marquage (8) peut être guidé le long du film de tampon (1) et que celui-ci est conçu appliquant une force de marquage.

9. Dispositif pour marquer un motif de marquage sur une surface de marquage (60) comprenant les caractéristiques suivantes :
- une réception de tampon pour recevoir et déplacer un tampon structurel (5) selon l'une des revendications précédentes,
- une réception de matériau de marquage pour recevoir et agencer un matériau de marquage (6) par rapport au tampon structurel (5),
- un entraînement d'élément de marquage pour déplacer l'élément de marquage (8) le long du tampon structurel (5).

10. Procédé destiné au marquage d'un modèle de marquage sur une surface de marquage d'un matériau de marquage comprenant les étapes suivantes, en particulier le déroulement suivant :
- agencement de la surface de tampon d'un tampon structurel selon l'une des revendications 1 à 8 par rapport au matériau de marquage,
- déplacement de l'élément de marquage le long du tampon structurel et en cela, application du tampon structurel avec la force de ligne et ainsi marquage du matériau de marquage par application du matériau de marquage avec la surface de tampon.

11. Procédé selon la revendication 10, dans lequel le tampon est conçu flexible et lors du marquage, est étiré par l'élément de marquage au-delà d'un plan superficiel défini par le cadre, en particulier par les baguettes de guidage.

12. Procédé selon la revendication 10 ou 11, dans lequel le cadre est reçu par un cadre de fixation sur son côté détourné de la surface de tampon.

13. Procédé selon la revendication 12, dans lequel l'élément de marquage est dirigé entre le cadre de fixation et le cadre, en particulier parallèlement aux côtés de serrage opposés, le long du tampon, et celui-ci est alors appliqué avec une force de marquage.
